Europäisches Patentamt

European Patent Office

Office européen des brevets

(11) Veröffentlichungsnummer: **0 364 619 B1**

(12) **EUROPÄISCHE PATENTSCHRIFT**

(45) Veröffentlichungstag der Patentschrift: **29.12.93**

(51) Int. Cl.5: **H01J 37/20**

(21) Anmeldenummer: **88117372.8**

(22) Anmeldetag: **19.10.88**

(54) **Vorrichtung zum Plasma- oder reaktiven Ionenätzen und Verfahren zum Ätzen schlecht wärmeleitender Substrate.**

(43) Veröffentlichungstag der Anmeldung:
**25.04.90 Patentblatt 90/17**

(45) Bekanntmachung des Hinweises auf die Patenterteilung:
**29.12.93 Patentblatt 93/52**

(84) Benannte Vertragsstaaten:
**DE FR GB**

(56) Entgegenhaltungen:
EP-A- 0 072 673
EP-A- 0 115 970
DE-A- 2 744 534

RESEARCH DISCLOSURE, Nr. 262, Februar 1986, Nr. 26238, Emsworth, Hampshire, GB; "Backside etch of silicon nitride on device wafers"

PATENT ABSTRACTS OF JAPAN, Band 8, Nr. 198 (E-265)[1635], 11. September 1984;& JP-A-59 86 147

PATENT ABSTRACTS OF JAPAN, Band 7, Nr. 99 (E-172)[1244], 27. April 1983;& JP-A-58 21 327

(73) Patentinhaber: **IBM DEUTSCHLAND GMBH**
**Pascalstrasse 100**
**D-70569 Stuttgart(DE)**

(84) Benannte Vertragsstaaten:
**DE**

(73) Patentinhaber: **International Business Machines Corporation**
**Old Orchard Road**
**Armonk, N.Y. 10504(US)**

(84) Benannte Vertragsstaaten:
**FR GB**

(72) Erfinder: **Bayer, Thomas**
**Hinterweiler Strasse 45**
**D-7032 Sindelfingen(DE)**
Erfinder: **Bartha, Johann, Dr.**
**Hohenstaufenstrasse 18**
**D-7032 Sindelfingen(DE)**
Erfinder: **Greschner, Johann, Dr.**
**Tiergartenweg 14**
**D-7401 Pliezhausen 1(DE)**
Erfinder: **Kern, Dieter**
**Farese Way**
**Amawalk**
**Yorktown, N.Y. 10501(US)**

Erfinder: **Mattern, Volker**
**Amsterdamer Strasse 35**
**D-7030 Böblingen(DE)**
Erfinder: **Stöhr, Roland**
**Kniebisweg 2**
**D-7045 Nufringen(DE)**


(74) Vertreter: **Mönig, Anton, Dipl.-Ing.**
**IBM Deutschland Informationssysteme**
**GmbH,**
**Patentwesen und Urheberrecht**
**D-70548 Stuttgart (DE)**

**Beschreibung**

Die vorliegende Erfindung betrifft eine Vorrichtung zum Plasma- oder reaktiven Ionenätzen (RIE) und ein Verfahren zum Ätzen schlecht wärmeleitender Substrate, insbesondere von Kunststoffsubstraten, in dieser Vorrichtung.

In den letzten Jahren hat beim Ätzen von Halbleitersubstraten, dielektrischen Materialien und Kunststoffsubstraten ein Übergang von naßchemischen Ätzverfahren zu sog. Trocken- oder Plasmaätzverfahren stattgefunden. Solche "trocken", d. h. im Vakuum durchgeführten Prozesse, die vor allem in der Halbleitertechnologie aber auch bei der Bearbeitung von Kunststoffen angewendet werden, erfordern eine genaue Kontrolle der Temperatur. So ist beispielsweise bei Ätzprozessen wie PE (Plasma Etching), RIE (Reactive Ion Etching), ECR (Electron Cyclotron Resonance Plasma Etching), MRIE (Magnetic Confinement Reactive Ion Etching), Triode Etching, CAIBE (Chemically Assisted Ion Beam Etching), Photon Assisted Etching und dergl. eine Kühlung notwendig, um die zu ätzenden Substrate oder auf ihnen aufgebrachte Schichten, wie z. B. Photoresistschichten, vor Schäden zu bewahren.

Deshalb werden im allgemeinen die Substrathalter zur Temperierung mit Flüssigkeiten wie Wasser oder speziellen Ölen durchspült. Die Wärmeübertragung zwischen Substrat und Substrathalter wird allerdings durch den Spalt zwischen beiden behindert, was zu einer Reihe von Verbesserungsvorschlägen führte. In der U.S. Patentschrift 4,282,924 wird beispielsweise eine Vorrichtung zur Ionenimplantation beschrieben, bei der die Substrate auf die konvex gekrümmte Oberfläche eines Substrathalters mittels eines Rings oder Klammern angepreßt werden und der Wärmeübergang zwischen den Substraten und dem Substrathalter, der von einer Kühlflüssigkeit durchströmt wird, durch eine dünne Zwischenlage aus einem Elastomeren verbessert wird. In der U.S. Patentschrift 4,399,016 ist ein Substrathalter beschrieben, bei dem der Kontakt zum Substrat durch Anpressen desselben über elektrostatische Anziehung zwischen Substrat und dem hiervon elektrisch isolierten Substrathalter verbessert wird. Durch Auffüllen des Spalts zwischen Substrat und Substrathalter mit einem flüssigen Metall kann der Wärmeübergang ebenfalls verbessert werden (U.S. Patent 4,129,881).

Am effektivsten kann ein Gegenstand während der Behandlung im Vakuum gekühlt werden, wenn ein Gas mit hoher Wärmeleitfähigkeit zwischen den zu behandelnden Gegenstand, beispielsweise einen Halbleiterwafer, und den Substrathalter eingeleitet wird. Als Gase haben sich Stickstoff, Neon, Wasserstoff und insbesondere Helium bewährt (U. S. Patent 4,514,636 und viele andere). Die Wärmeübertragung zwischen Halbleiterwafer und Substrathalter ist allerdings nur dann effektiv, wenn dort ein statischer Gasdruck zwischen etwa 1.33 und 13.3 mbar, vorzugsweise von etwa 1.33 mbar aufrechterhalten werden kann. Dies wiederum erfordert eine mechanische oder elektrostatische Befestigung der zu behandelnden Substrate auf dem flüssigkeitsgekühlten Substrathalter und eine Abdichtung gegenüber dem Reaktionsraum, damit ein Übertritt des wärmeübertragenden Gases, das das Produktionsergebnis empfindlich beeinträchtigen kann, vermieden wird.

Die zuvor beschriebenen Vorrichtungen und Verfahren setzen mechanisch stabile Substrate voraus, die sich gut einspannen und gegen den Reaktionsraum abdichten lassen. Die Wärmeabfuhr erfolgt in allen diesen Fällen durch Wärmeleitung in Materie bzw. durch Konvektion in Gas, wobei die Gleichmäßigkeit der Kühlung von der Art der Auflage des Substrats auf dem Substrathalter bzw. der Homogenität und dem Druck des wärmeleitenden Gases abhängt. Nur in wenigen Spezialfällen wird das Substrat ganzflächig auf dem Substrathalter aufliegen. Normalerweise wird die Auflage eine Mehrpunktauflage sein, was aber kein Problem darstellt, wenn die Ätzrate, beispielsweise beim Plasma- oder reaktiven Ionenätzen, nicht temperaturabhängig ist und/oder wenn die Wärmeleitfähigkeit der zu ätzenden Substrate sehr hoch ist, wodurch auch in diesen Fällen eine Gleichmäßigkeit der Substrattemperatur gewährleistet ist.

Es gibt aber auch Substratmaterialien, deren Ätzrate stark temperaturabhängig ist. Dies trifft insbesondere für Kunststoffsubstrate zu. Häufig haben diese Kunststoffe auch eine schlechte Wärmeleitfähigkeit, so daß es bei einer Substratbefestigung und Kühlung nach dem zuvor beschriebenen Stand der Technik zu erheblichen Unregelmäßigkeiten der Ätzraten kommen kann. So wurden beispielsweise beim reaktiven Ionenätzen von Substraten aus Polyoxymethylenhomo- oder Copolymerisaten Ätzratenunterschiede um mehr als einen Faktor 2 innerhalb weniger Quadratzentimeter Substratfläche festgestellt, was zu einer schlechten Ausbeute führte.

Aufgabe der Erfindung ist, eine Vorrichtung zum Plasma- oder reaktiven Ionenätzen von schlecht wärmeleitenden Substraten, insbesondere von Kunststoffsubstraten, anzugeben, in der sowohl eine gleichmäßige Temperierung der Substrate als auch eine gleichmäßige Behandlung über die gesamte Substratfläche möglich ist.

Die Aufgabe der Erfindung wird gelöst durch eine Vorrichtung gemäß Patentanspruch 1.

Die Erfindung umfaßt auch ein Verfahren, welches in dieser Vorrichtung durchgeführt wird.

Ein Ausführungsbeispiel der Vorrichtung gemäß der Erfindung wird später anhand der Fign. 1 bis 5 näher erläutert.

Es zeigen:

Fig. 1      eine Vorrichtung zur Behandlung eines Substrats in einem reaktiven Ionenätzprozeß;

Fig. 2      einen Ausschnitt aus einer Kathodenanordnung gemäß Fig. 1;

Fig. 3      einen Außchnitt aus einer weiteren Kathodenanordnung gemäß Fig. 1;

Fig. 4      einen Querschnitt einer Durchführungsöffnung in einem Kunststoffsubstrat in vergrösserter Darstellung nach dem reaktiven Ionenätzen.

Bei Plasma- oder reaktiven Ionenätzverfahren werden die zu behandelnden Substrate auf der unteren temperaturgeregelten Elektrode eines Parallelplattenreaktors angeordnet, die in der Regel beim Plasmaätzen geerdet ist und an die beim reaktiven Ionenätzen eine Spannung angelegt wird. Es wird bei Drucken zwischen etwa 100 und $10^{-3}$ mbar gearbeitet, wobei beim reaktiven Ionenätzen Drucke von etwa $10^{-2}$ bis $10^{-3}$ mbar angewendet werden. Der Druck wird durch die Leistung der Vakuumpumpe und durch den Gesamtfluß des Prozeßgases, der typischerweise zwischen etwa etwa $3 \times 10^{-3}$ und $3 \times 10^{-1}$ l/min (etwa 3 und 300 sccm) liegt, eingestellt. Das Prozeßgas wird elektrisch oder optisch angeregt, wobei die elektrische Anregung durch eine Niedertemperatur-Plasmaentladung, die mittels Gleichspannung, oder Wechselspannung erzeugt wird und die optische Anregung beispielsweise durch Laserstrahlen oder UV-Licht erfolgen kann. Das Auftreffen angeregter Teilchen wie Ionen, Radikale, Atome oder Moleküle auf die zu behandelnden Substrate stellt einen merklichen Energiefluß zu den Substraten dar und bewirkt eine Erwärmung derselben, der, wie eingangs erläutert, durch eine Temperaturregelung des Substrathalters entgegengewirkt werden muß.

Das Verfahren gemäß der Erfindung wird anhand des Herstellungsverfahrens beliebig geformter mikromechanischer Bauteile aus planparallelen Platten aus Polymermaterial oder beliebig geformter Durchführungsöffnungen in denselben durch reaktives Ionenätzen näher erläutert. Dieses Verfahren ist Gegenstand der Europäischen Patentanmeldung 87104580.3. Die planparallelen Platten aus Polyoxymethylenhomo- oder Copolymerisaten mit den nach dem dort beschriebenen Verfahren eingebrachten Rund- und Langlöchern werden vorzugsweise in einem Drahtführungskonzept von Testköpfen für Mehrschichtkeramiksubstrate verwendet. Testköpfe dieser Art sind Gegenstand der Europäischen Patentanmeldung 87104577.9.

Nach dem in der Europäischen Patentanmeldung 87104580.3 beschriebenen Verfahren werden durch reaktives Ionenätzen Durchführungsöffnungen (41, Fig. 4) in etwa 1 mm dicke Platten mit einem Durchmeßer von etwa 2 bis 5 cm aus Polyoxymethylen (Handelsname Delrin, Hersteller du Pont de Nemours) eingebracht. Hierzu werden die Substrate (44), die beidseitig mit Photoresistmasken (42) mit Öffnungen (43) bedeckt sind, in ein RIE-System, beispielsweise Leybold-Heraeus VZK 550 A, eingebracht. Die Durchführungsöffnungen (41) werden durch RIE zuerst von der Vorderseite und dann, nach dem Wenden der Probe, von der Rückseite her bis zu einer Tiefe von etwa 2/3 der Substratdicke in das Delrin-Substrat (44) geätzt. Durch die Überlappung der beiden Ätzzonen im mittleren Bereich ist es möglich, hochwertige Durchführungsöffnungen, d. h. streng senkrechte Öffnungen mit ausgezeichneter Lagetoleranz von Eintritts- und Austrittsöffnungen auf Vorder- und Rückseite zu ätzen.

Das RIE wird in einem Sauerstoffplasma, welches gegebenenfalls bis zu 50 % Argon enthält; bei einem Gasfluß von etwa $5 \times 10^{-3}$ bis $10^{1}$ l/min (etwa 5 bis 100 sccm); in einem Druckbereich von etwa 1 bis 50 $\mu$bar und bei einer Gleichspannungs-Vorspannung von etwa 200 bis 900 Volt vorgenommen für eine Zeit, bis die gewünschte Ätztiefe erreicht ist. Die Parameter für das zuvor angegebene RIE-System sind:

| | |
|---|---|
| Druck: | 10 $\mu$bar; |
| Gasfluß: | $3 \times 10^{-2}$ l/min (30 sccm) Sauerstoff, $1{,}2 \times 10^{-2}$ l/min (12 sccm) Argon; |
| HF-Amplitude: | 900 Volt; |
| Gleichspannungs-Vorspannung: | 890 Volt; |
| Substrattemperatur: | 70 °C; |
| Ätzrate: | 1.25 $\mu$m/Min. |

Wie bereits eingangs erläutert haben Kunststoffe in der Regel eine sehr schlechte Wärmeleitfähigkeit. Der Kunststoff Delrin beispielsweise hat eine Wärmeleitfähigkeit von etwa 0.3 Watt/m x °C und einen thermischen Ausdehnungskoeffizienten von etwa $110 \times 10^{-6}$ pro °C. Hierzu im Vergleich hat ein Siliciumwafer eine Wärmeleitfähigkeit von etwa 157 Watt/m x °C und einen thermischen Ausdehnungskoeffizienten von etwa $2.33 \times 10^{-6}$ pro °C. Zu dieser schlechten Wärmeleitfähigkeit des Delrinmaterials kommt hinzu, daß die Ätzrate dieses Materials stark temperaturabhängig ist. Eine effektive Kühlung der Substrate zu

4

deren gleichmäßiger Temperierung während des RIE ist deshalb besonders wichtig. Eine Befestigung der Delrinsubstrate auf der Kathode nach dem eingangs erläuterten Stand der Technik kann allerdings nicht in Frage kommen, weil, wegen des hohen Ausdehnungskoeffizienten des Kunststoffs Delrin, eine Ebenheit der Delrinsubstrate wie z. B. bei einem Siliciumwafer nicht gewährleistet werden kann.

Um die Probleme der Substratkühlung durch Wärmeleitung bei schlecht wärmeleitenden oder Kunststoffsubstraten zu vermeiden, werden gemäß der Erfindung die Substrate in der Weise auf einer geeigneten Kathode befestigt, daß die entstehende Wärme im wesentlichen über Wärmestrahlung abgeführt wird. Dazu muß das Substrat in einem definierten Abstand über der Kathode angeordnet und spannungsfrei gehalten werden. Da der RIE-Prozeß in einem Druckbereich von etwa $10^{-2}$ bis $10^{-3}$ mbar durchgeführt wird, kann bei einer solchen Anordnung die Wärmeabfuhr über Gaskonvektion weitgehend vernachläßigt werden, denn eine Kühlung durch Gaskonvektion wird erst bei einem Gasdruck von etwa 1.33 mbar effektiv, siehe hierzu U.S. Patent 4,514,636 und IBM-TDB Vol. 31, Nr. 1, Juni 1988, S. 462 bis 464, G. Fortuno et al., ELECTROSTATIC WAFER HOLDER FOR WAFER COOLING DURING REACTIVE ION ETCHING.

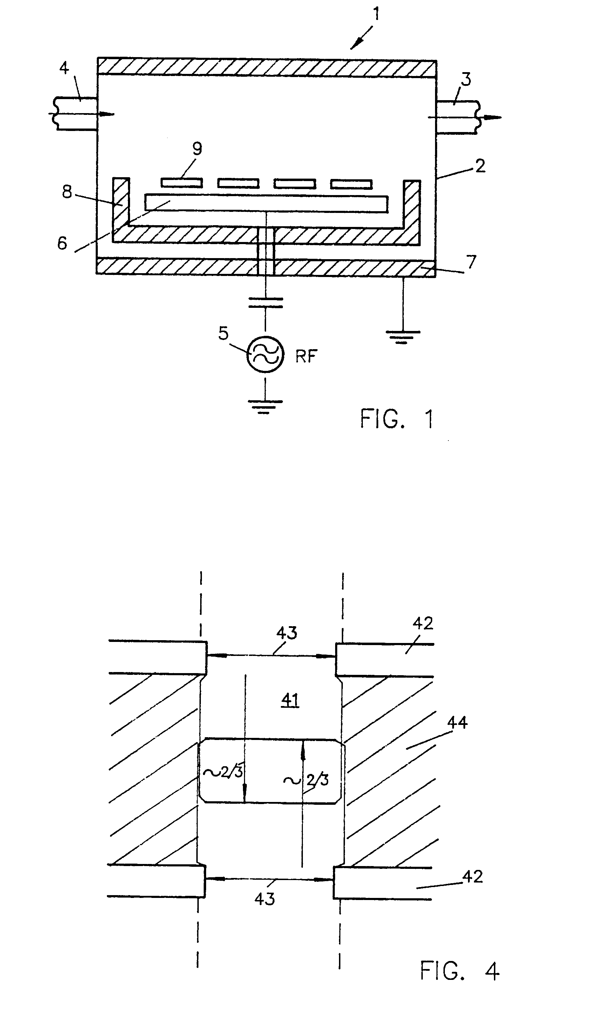

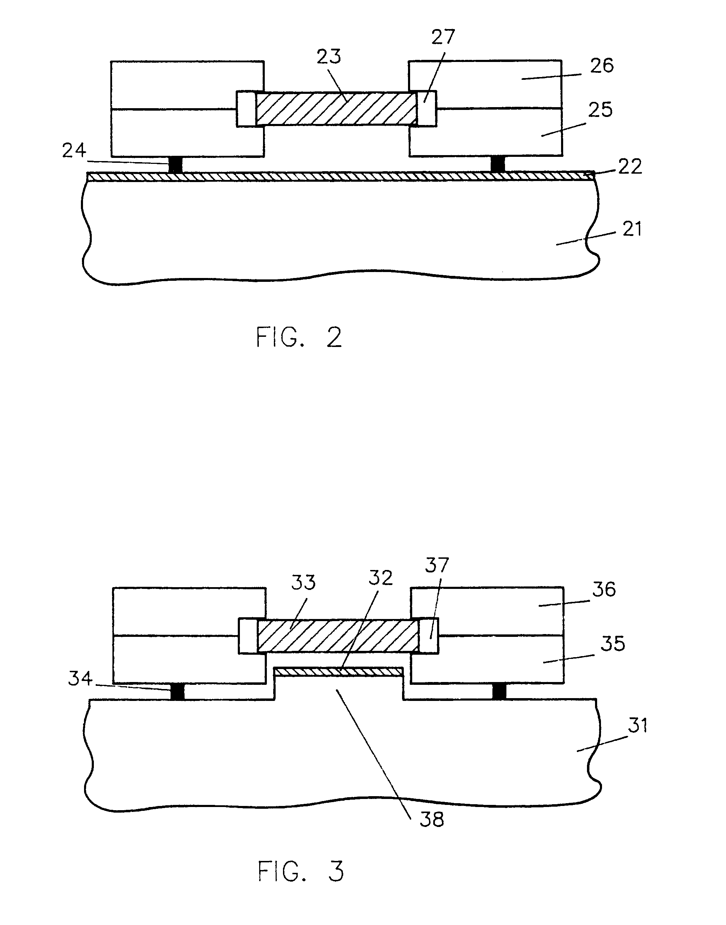

In den Fign. 1 bis 3 sind eine Vorrichtung bzw. 2 Kathoden mit Halterungen gezeigt, in denen die Substrate während des RIE in definiertem Abstand über der Kathode angeordnet werden können. In Fig. 1 ist eine RIE Vorrichtung (1) mit einer Prozeßkammer (2) dargestellt, die als Vakuum-Rezipient ausgebildet ist und mit einem Anschluß (3) zu einer Vakuumpumpe und einem Einlaß (4) zum Einleiten eines Prozeßgases versehen ist. Zur Kammer (2) gehört auch eine Energiequelle (5), mit der die Kathode (6) mit elektrischer Energie beaufschlagt wird. Die Rückseite der Kathode (6) ist von einem geerdeten Schirm (8) umgeben, und die Wandung der Kammer (2) bildet die geerdete Anode (7). Die zu ätzenden Substrate (9) sind in einer Halterung in definiertem Abstand über der Kathode (6) angeordnet. Einzelheiten hierzu sind aus den Fign. 2 und 3 ersichtlich.

Fig. 2 zeigt ein Delrin-Substrat (23), das beidseitig geätzt werden soll, in einem zweiteiligen Keramikrahmen (25, 26). Der Keramikrahmen wird auf die Kathode über schlecht wärmeleitende Distanzstücke (24) aufgedrückt. Damit sich das Delrin-Substrat während des Erwärmens ausdehnen kann, sind in den Halterungen beidseitig Hohlräume (27) vorgesehen. Die Kathode (21) besteht aus Aluminium und ist an ihrer Oberfläche mit einem schwarzen Strahler (22), hier mit einer schwarz eloxierten Schicht versehen. Die schwarz eloxierte Oberfläche ist besonders vorteilhaft, sowohl hinsichtlich ihres Wirkungsgrades als Absorber als auch hinsichtlich ihrer Resistenz während des RIE. Der Abstand des Substrats zur Kathode beträgt bei der gezeigten Anordnung etwa 0.5 mm.

In allen Versuchen wird die Substrattemperatur mit einem Pyrometer gemessen.

Wenn das Substrat nach dem Stand der Technik in direkten Kontakt mit der Kathode gebracht wird, dann stellt sich bei einer bestimmten Plasmaleistung, beispielsweise bei 660 Volt RF und bei Abführung der im Substrat erzeugten Wärme durch Wärmeleitung zur Kathode eine Substrattemperatur von etwa 40°C ein.

In einem weiteren Versuch wird das Substrat in einem Abstand von etwa 3 mm "schwebend" über einer Kathode, deren Oberfläche nicht mit einem schwarzen Strahler versehen ist, angeordnet. Es erreicht dann, bei gleicher Leistung, die höhere Endtemperatur von etwa 93°C. Dies ist darauf zurückzuführen, daß das Substrat praktisch nur auf den zwei Distanzstücken aus Quarz aufliegt, welche eine sehr geringe Wärmeleitung zur Kathode zulassen und daß der Großteil der durch das Plasma im Substrat erzeugten Wärme durch Wärmestrahlung abgeführt wird. Die bei dieser Anordnung deutlich höhere Substrattemperatur ist unter Umständen ein Nachteil, der in Kauf genommen werden muß gegenüber einer Anordnung, bei der die Substrate direkt auf der Kathode aufliegen. Ein grosser Vorteil dieser Anordnung ist aber darin zu sehen, dass bei Substraten mit geringer Eigenwärmeleitfähigkeit eine wesentlich gleichmäßigere Temperaturverteilung und damit eine bessere Ätzratenuniformität erhalten wird.

Aufgrund von Meßungen wurde festgestellt, daß die bei der zuletzt beschriebenen Substrathalterung vom Substrat in Richtung Aluminiumkathode abgestrahlte Wärmestrahlung von der Aluminiumoberfläche weitgehend reflektiert wird und dadurch das Substrat zusätzlich aufheizt. Durch Beschichten der Aluminiumoberfläche mit einem schwarzen Strahler, bzw. durch Eloxieren (Fig. 2) kann eine Absorption dieser Strahlung bewirkt werden, wodurch die Substrattemperatur von etwa 93°C auf etwa 70 °C abgesenkt werden kann. Der Abstand des Substrats zur Kathode beträgt etwa 0.5 mm. Hinsichtlich der Temperatur- und der Ätzratenuniformität ist die in Fig. 2 dargestellte Kathodenanordnung sehr vorteilhaft. Sie ist jedoch noch verbesserungsbedürftig im Hinblick auf die elektrische Uniformität, d. h. im Hinblick darauf, daß überall ein senkrechter Einfall der Ionen auf das Substrat während des RIE gewährleistet ist.

Ein ungestörter senkrechter Einfall der Ionen auf die Kathodenoberfläche während des RIE ist nur bei einer vollkommen ebenen, unendlich ausgedehnten Kathodenoberfläche gewährleistet. Jede geometrische Störung der Kathodenoberfläche führt zu Verbiegungen der Äquipotentialflächen, d. h. zu deren Abweichung von der Parallelität zur Substratoberfläche und, weil der dreidimensionale Verlauf der Äquipotential-

5

EP 0 364 619 B1

flächen die Bahnen der Ionen bestimmt, zu einer Störung des senkrechten Einfalls der Ionen. Die Anordnung von Fig. 2 z. B. wirkt wie ein nichtebenes Dielektrikum in einem Plattenkondensator, der durch die Dunkelraumkante und die Kathodenoberfläche gebildet wird. Experimentell konnte nachgewiesen werden, daß zu ätzende Strukturen, die sich in der Nähe der Kanten der Keramikhalterung (25, 26) befinden, schräg geätzt werden. Dies ist vernachläßigbar, wenn die zu ätzenden Strukturen nicht allzu tief sind. Wenn dagegen die zu ätzenden Strukturen sehr tief sind, oder gar Durchgangslöcher wie z. B. in die Delrinsubstrate geätzt werden sollen (Fig. 4), dann können schräg geätzte Strukturen nicht mehr toleriert werden. Der experimentelle Befund konnte auch rechnerisch sehr gut bestätigt werden. Der Berechnung wurden für die Distanz zwischen Keramik und Kathodenoberfläche 0.2 mm, für die Dicke der Keramik-Haltelippen 0.8 mm und für die Dicke der Delrinsubstrate 1 mm zugrunde gelegt. Als Dielektrizitätskonstanten wurden für Delrin $\epsilon$ = 2.9 und für die Keramik $\epsilon$ = 9 verwendet. Der Dunkelraum während des RIE war 15 mm groß, und das DC-Potential war 500 V. Die Rechnung zeigte, daß ein Ion, das in einem Abstand von etwa 4 mm vom Keramikrand auf ein 1 mm dickes Substrat in einem Substrathalter gemäß Fig. 2 trifft, eine Neigung von etwa 1.5° gegenüber der Senkrechten hat, was bei 1 mm Substratdicke einem Versatz der Öffnungen auf Vorder- und Rückseite von 28,92 $\mu$m entspricht.

Der Effekt des Schrägätzens kann mit einer Anordnung gemäß Fig. 3 verringert werden. Fig. 3 zeigt ein Delrin-Substrat (33), das beidseitig geätzt werden soll, in einem zweiteiligen Keramikrahmen (35, 36). Der Keramikrahmen wird auf die Kathode über schlecht wärmeleitende Distanzstücke (34) aufgedrückt. Damit sich das Delrin-Substrat während des Erwärmens ausdehnen kann, sind in den Halterungen beidseitig Hohlräume (37) vorgesehen. Die Kathode (31) besteht aus Aluminium. Sie unterscheidet sich von der in Fig. 2 gezeigten Anordnung durch eine veränderte Kathodenoberfläche. Die Kathode (31) ist im Bereich des zu ätzenden Substrats (33) erhöht und in Form eines Sockels (38) bis auf einen Abstand von etwa 0.2 mm an die Substratunterseite herangeführt. Im Bereich des Substrats ist ihre Oberfläche mit einem schwarzen Strahler (32), hier mit einer schwarz eloxierten Schicht versehen. Durch diese besondere Ausgestaltung der Kathode, welche einen senkrechten Einfall der Ionen, insbesondere im Randbereich der Substrathalterung gewährleistet, konnten die Fehlbeträge durch Schrägätzen auf etwa die Hälfte reduziert werden. Die experimentellen Ergebnisse wurden auch rechnerisch bestätigt.

Mit der erfindungsgemäßen Anordnungen Kathode und Halterung (Fign. 2 und 3) können alle Arten von Substraten, die schlecht wärmeleitend und während des RIE temperaturempfindlich sind, mit hoher Ätzratenuniformität geätzt werden. Hinsichtlich der elektrischen Uniformität ist die Anordnung, die in Fig. 3 dargestellt ist, besonders vorteilhaft. Durch die hohe Ätzratenuniformität kann die Ausbeute bei den Ätzprozessen, insbesondere beim Ätzen von Drahtführungsplatten aus Delrin, wesentlich verbessert werden.

**Patentansprüche**

1. Vorrichtung zum Plasma- oder reaktiven Ionenätzen schlecht wärmeleitender Substrate mit hoher Ätzratenuniformität bestehend aus einer Prozeßkammer (2) mit einem Einlaß (4) für ein Prozeßgas und einem Anschluß (3) zu einer Vakuumpumpe; mindestens einem Substrathalter auf einer Elektrode (6), einer Gegenelektrode (7) und einer Energiequelle (5) zum Beaufschlagen der Elektrode oder der Gegenelektrode mit RF-Energie,
   dadurch gekennzeichnet,
   daß die Substrathalter in einem bestimmten Abstand von der Elektrode (6) angeordnet sind und auf der Elektrode (6) eine Wärmestrahlung absorbierende Schicht (22, 32) vorgesehen ist.

2. Vorrichtung nach Anspruch 1, dadurch gekennzeichnet, daß beim reaktiven Ionenätzen die Elektrode (6), auf der sich die zu ätzenden Substrate befinden, die mit RF-Energie beaufschlagte Kathode und die Gegenelektrode (7) die geerdete Anode ist, und daß beim Plasmaätzen die Elektrode (6) geerdet und die Gegenelektrode (7) mit RF-Energie beaufschlagt ist.

3. Vorrichtung nach Anspruch 2, dadurch gekennzeichnet, daß die Substrathalter (25, 26; 35, 36) in einem Abstand von mindestens 0.2 mm von der Kathode (22, 21; 32, 31) angeordnet sind.

4. Vorrichtung nach Anspruch 3, dadurch gekennzeichnet, daß die Oberfläche der Substrathalter parallel zur Oberfläche der Kathode verläuft.

5. Vorrichtung nach einem der Ansprüche 1, 3 oder 4, dadurch gekennzeichnet, daß die Substrathalter (25, 26; 35, 36) zweiteilig sind und aus Keramik bestehen.

6

**6.** Vorrichtung nach Anspruch 5, dadurch gekennzeichnet, daß in den Substrathaltern (25, 26; 35, 36) Hohlräume (27, 37) vorgesehen sind, damit sich die Substrate beim Erwärmen während des Ätzens ausdehnen können.

**7.** Vorrichtung nach einem der Ansprüche 2, 3 oder 4, dadurch gekennzeichnet, daß die Substrathalter (25, 35) über Distanzstücke (24, 34) auf die Kathode (22, 21; 32, 31) aufgedrückt werden.

**8.** Vorrichtung nach Anspruch 7, dadurch gekennzeichnet, daß die Kathode (21, 31) aus Aluminium besteht und ihre Oberfläche mit einer als schwarzer Strahler wirkenden Schicht bedeckt ist.

**9.** Vorrichtung nach Anspruch 8, dadurch gekennzeichnet, daß die Oberfläche der Aluminiumkathode (21, 31) schwarz eloxiert ist.

**10.** Vorrichtung nach einem der Ansprüche 2, 3 oder 4, dadurch gekennzeichnet, daß die Kathode (31) im Bereich des zu ätzenden Substrats (33) erhöht ist und in Form eines Sockels (38) bis auf einen Abstand von etwa 0.2 mm an die Substratunterseite herangeführt wird und im Bereich des Substrats mit einer als schwarzer Strahler wirkenden Schicht (32) versehen ist.

**11.** Verfahren zum Betrieb einer Vorrichtung nach den Ansprüchen 1 bis 10 bei einem Druck zwischen etwa 100 und $10^{-3}$ mbar mit durch elektrische oder optische Energie angeregten Teilchen unter Zufuhr eines die Teilchen liefernden Prozeßgases,
dadurch gekennzeichnet,
daß die Substrate vor dem Ätzen mittels einer Halterung in einem Abstand von der Kathodenoberfläche angeordnet werden und die während des Ätzens entstehende Wärme mittels Wärmestrahlung abgeführt wird.

**12.** Verfahren nach Anspruch 11, dadurch gekennzeichnet, daß die Substrate in einem Abstand von etwa 0.2 bis etwa 3 mm von der Kathodenoberfläche angeordnet werden.

**13.** Verfahren nach Anspruch 11, dadurch gekennzeichnet, daß die von der Kathode auf die Substrate zurückreflektierte Wärmestrahlung in einer auf der Kathodenoberfläche angeordneten Schicht absorbiert wird.

**14.** Verfahren nach den Ansprüchen 11 bis 13, dadurch gekennzeichnet, daß in Kunststoffsubstraten von etwa 1 mm Dicke durch reaktives Ionenätzen Durchgangslöcher erzeugt werden.

**15.** Verfahren nach Anspruch 14, dadurch gekennzeichnet, daß das reaktive Ionenätzen in einem Sauerstoffplasma, dem gegebenenfalls Argon zugesetzt wird, bei einem Gasfluß von etwa 5 x $10^{-3}$ bis $10^{-1}$ l/min (etwa 5 bis 100 sccm), in einem Druckbereich von etwa 1 bis 50 $\mu$bar und bei einer Gleichspannungs-Vorspannung von etwa 200 bis 900 Volt vorgenommen wird für eine Zeit, bis die gewünschte Ätztiefe erreicht ist.

**Claims**

**1.** Apparatus for plasma- or reactive ion etching of substrates having a low thermal conductivity at a high degree of etch rate uniformity, comprising a process chamber (2) with an inlet (4) for a process gas and a connector (3) for a vacuum pump; at least one substrate holder on an electrode (6), a counterelectrode (7), and an energy source (5) for applying RF energy to the electrode or the counterelectrode, characterized in that the substrate holders are arranged at a predetermined spacing from the electrode (6) and the electrode is provided with a thermal radiation absorbing layer (22, 32).

**2.** Apparatus according to claim 1, characterized in that during reactive ion etching, the electrode (6), on which the substrates to be etched are arranged, is the cathode subjected to RF energy, and the counterelectrode (7) is the grounded anode, and that during plasma etching, the electrode (6) is grounded and the counterelectrode (7) is subjected to RF energy.

**3.** Apparatus according to claim 1, characterized in that the substrate holders (25, 26; 35, 36) are arranged at a spacing of at least 0.2 mm from the cathode (22, 21; 32, 31).

**4.** Apparatus according to claim 3, characterized in that the surface of the substrate holders extends parallel to the surface of the cathode.

**5.** Apparatus according to any one of claims 1, 3 or 4, characterized in that the holders (25, 26; 35, 36) for the substrate consist of two pieces and are made of a ceramic material.

**6.** Apparatus according to claim 5, characterized in that hollow spaces (27, 37) are provided in the holders (25, 26; 35, 36) to permit the substrates to expand as they become heated during etching.

**7.** Apparatus according to any one of claims 2,3 or 4, characterized in that the substrate holders (25, 35) are forced against the cathode (22, 21; 32, 31) by spacers (24, 34).

**8.** Apparatus according to claim 7, characterized in that the cathode (21, 31) is made of aluminium and that its surface is coated with a layer acting as a black radiator.

**9.** Apparatus according to claim 8, characterized in that the surface of the aluminium cathode (21, 31) is provided with a black anodized layer.

**10.** Apparatus according to any one of claims 2,3 or 4, characterized in that in the area of the substrate (33) to be etched, the cathode (31) is raised and is led to the bottom side of the substrate in the form of a pedestal (38) to within a spacing of about 0.2 mm and in the area of the substrate, said cathode being provided with a layer (32) acting as a black radiator.

**11.** Method for operating an apparatus according to claims 1 to 10 at a pressure ranging from about 100 to $10^{-3}$ mbar by electrically or optically energized particles, using a process gas supplying said particles, characterized in that by means of a holder, the substrates are kept at a predetermined distance from the cathode surface before etching and the heat formed during etching is removed by radiation.

**12.** Method according to claim 11, characterized in that the substrates are kept at a spacing of about 0.2 to about 3 mm from the cathode surface.

**13.** Method according to claim 11, characterized in that the heat reflected from the cathode to the substrates is absorbed by a layer covering the cathode surface.

**14.** Method according to claims 11 to 13, characterized in that throughholes in of a thickness of about 1 mm in plastic substrates are provided by reactive ion etching.

**15.** Method according to claim 14, characterized in that reactive ion etching is carried out in an oxygen plasma, to which argon may be added, if required, at a gas flow of about 5 x $10^{-3}$ to $10^{-1}$ l/min (about 5 to 100 sccm), a pressure ranging from about 1 to 50 $\mu$bar and a single-phase D.C. bias of about 200 to 900 V for a time sufficient to obtain the desired etch depth.

**Revendications**

**1.** Dispositif de corrosion plasmatique ou ionique réactive des substrats à mauvaise conductibilité thermique, avec une grande uniformité du taux de corrosion, composé d'une chambre de processus (2), avec une entrée (4) destinée à un gaz de processus et un branchement (3) en direction d'une pompe à vide; au moins un support de substrats sur une électrode (6), une contre-électrode (7) et une source d'énergie (5) destinée à appliquer une énergie RF sur l'électrode ou la contre-électrode, caractérisée par
le fait que les supports de substrats sont agencés à une certaine distance de l'électrode (6) et qu'une couche permettant d'absorber le rayonnement calorifique (22, 23) a été prévue sur l'électrode (6).

**2.** Dispositif suivant la revendication 1, caractérisé par le fait que l'électrode (6), sur laquelle se trouvent les substrats devant être corrodés, est constituée, lors de la corrosion ionique réactive, par la cathode sur laquelle on applique une énergie RF et que la contre-électrode (7) est constituée par l'anode mise à la terre, et que l'électrode (6) est mise à la terre, lors de la corrosion plasmatique, tandis que la contre-électrode (7) se voit appliquer une énergie RF.

**3.** Dispositif suivant la revendication 2, caractérisé par un agencement des supports de substrats (25, 26; 35, 36) à une distance d'au moins 0,2 mm de la cathode (22, 21; 32, 31).

**4.** Dispositif suivant la revendication 3, caractérisé par une surface des supports de substrats parallèle à la surface de la cathode.

**5.** Dispositif suivant l'une des revendications 1, 3 ou 4, caractérisé par des supports de substrats (25, 26; 35, 36) constitués de deux parties en céramique.

**6.** Dispositif suivant la revendication 5, caractérisé par la présence d'espaces creux (27, 37), à l'intérieur des supports de substrats (25, 26; 35, 36), pour que les substrats puissent se dilater, lors de l'échauffement qui se produit pendant la corrosion.

**7.** Dispositif suivant l'une des revendications 2, 3 ou 4, caractérisé par le fait que les supports de substrats (25, 35) sont appliqués sur la cathode (22, 21; 32, 31) par l'intermédiaire de pièces intercalaires (24, 34).

**8.** Dispositif suivant la revendication 7, caractérisé par une cathode (21, 31) en aluminium, dont la surface est recouverte d'une couche agissant comme une source de rayonnement noire.

**9.** Dispositif suivant la revendication 8, caractérisé par une surface de la cathode (21, 31) en aluminium oxydée électrolytiquement en noir.

**10.** Dispositif suivant l'une des revendications 2, 3 ou 4, caractérisé par un rehaussement de la cathode (31) dans la zone du substrat devant être corrodé (33) et par le fait qu'elle est approchée, sous forme de socle (38), de la face inférieure du substrat, jusqu'à une distance d'environ 0,2 mm et quelle est pourvue, dans la zone du substrat, d'une couche (32) agissant comme une source de rayonnement noire.

**11.** Procédé destiné à la mise en oeuvre d'un dispositif, suivant les revendications 1 à 10, avec une pression comprise entre environ 100 et $10^{-3}$ mbar, avec des particules excitées par énergie électrique ou optique, suite à l'amenée d'un gaz de processus fournissant ces particules,
caractérisé par
des substrats agencés, avant le processus de corrosion, à distance de la surface de la cathode, au moyen d'une fixation et par l'évacuation de la chaleur produite lors de la corrosion, grâce à un rayonnement calorifique.

**12.** Procédé suivant la revendication 11, caractérisé par un agencement des substrats à une distance d'environ 0,2 mm à environ 3 mm, de la surface de la cathode.

**13.** Procédé suivant la revendication 11, caractérisé par l'absorption du rayonnement calorifique réfléchi par la cathode sur les substrats, dans une couche agencée à la surface de la cathode.

**14.** Procédé suivant les revendications 11 à 13, caractérisé par la production d'ouvertures de traversée, dans des substrats en matière plastique d'une épaisseur d'environ 1 mm, grâce à une corrosion ionique réactive.

**15.** Procédé suivant la revendication 14, caractérise par la réalisation de la corrosion ionique réactive, dans un plasma d'oxygène, auquel on a additionné de l'argon, le cas échéant; avec un flux gazeux d'environ $5 \times 10^{-3}$ à $10^{-1}$ l/min. (environ 5 à 100 sccm); dans une plage de pression d'environ 1 à 50 $\mu$bar et avec une tension de polarisation en tension continue d'environ 200 à 900 Volt, jusqu'à ce que la profondeur de corrosion souhaitée soit atteinte.

FIG. 1

FIG. 4

FIG. 2

FIG. 3